# EUROPEAN PATENT SPECIFICATION

(11) **EP 0 634 575 B1**
(45) Date of publication and mention of the grant of the patent: **06.05.1998**
(21) Application number: 94830345.8
(22) Date of filing: 11.07.1994
(51) Int. Cl.: F03H 1/00, H01J 27/02, H01J 37/32

(54) **Device for distributing a gaseous component in ionization chambers, for space thrusters**
Vorrichtung zur Verteilung einer gasförmigen Komponente in Ionisationskammern für Raumfahrtantrieb
Dispositif de distribution d'un composant gazeux dans des chambres d'ionisation pour propulseurs spaciaux

(30) Priority: 13.07.1993 IT FI930129
(43) Date of publication of application: 18.01.1995
(73) Proprietor: LABEN S.p.A., Vimodrone (Milano) (IT)
(72) Inventor: Cirri, Gianfranco, I-50129 Firenze (IT)
(74) Representative: Mannucci, Michele

(56) References cited:
- EP-A- 0 535 304
- INTERNATIONAL JOURNAL OF MASS SPECTROMETRY AND ION PROCESSES, vol.96, 1990, AMSTERDAM NL pages 139 - 167 A. DANON ET AL. 'HYPERTHERMAL SURFACE IONISATION: A NOVEL ION SOURCE WITH ANALYTICAL APPLICATIONS'
- REVIEW OF SCIENTIFIC INSTRUMENTS., vol.58, no.9, September 1987, NEW YORK US pages 1724 - 1726 A. DANON ET AL. 'CERAMIC NOZZLE FOR MOLECULAR ACCELERATION AND ITS TEMPERATURE MEASUREMENT'
- JOURNAL OF VACUUM SCIENCE AND TECHNOLOGY: PART A., vol.9, no.4, August 1991, NEW YORK US pages 2414 - 2417 S. M. COHEN 'AN APERTURE-VALVE ASSEMBLY FOR CALIBRATED, REPETITIVE GAS DOSES'

## Description

The invention relates to an ionization chamber including means for generating electrical or magnetic fields for ionization and a gas distribution device including at least one nozzle with a calibrated hole for the discharge of said gas into said ionization chamber.

Devices which use ionization chambers in which, by the application of a suitable electrical field and possibly a magnetic field, the ionization of a gas is achieved, are known and used in various technological applications; for example, in surface treatments there are various devices which, by the ionization of one or more gases, can be used for processes such as the deposition of thin films on targets placed in front of the device ("deposition"), or the selective erosion of certain layers of the target ("etching"), and other purposes.

These ion sources, if suitably configured, may also be used in the space field for various applications, primarily electrical propulsion. In this last case, the device is normally known as an electrical thruster, and in summary consists of a chamber made of any of various materials, generally cylindrical in shape, into which the propellant (gas) is introduced through a suitable gas distributor, and in which the propellant is ionized; suitable electrically conditioned means designed to create a discharge in the gas; and further means capable of accelerating the ionized gas towards the outside. This device is used to generate the plasma which is accelerated towards the outside and is thus capable of producing a thrust. An example of ion thruster is disclosed in EP-A-0535304.

The invention relates to an innovative technological solution for the distribution of the gas within ionization devices, such as those illustrated above as non-restrictive examples.

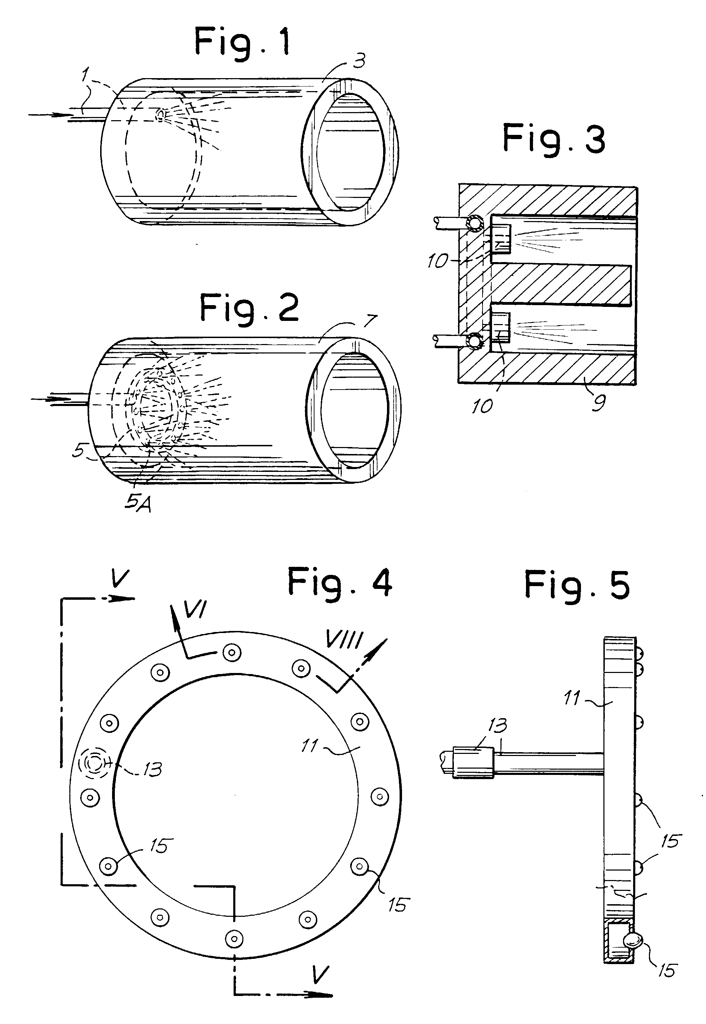

Generally, the propellant enters the discharge chambers of user devices through a flow line which carries the gas from a reservoir or container (for example, a cylinder) of the gas, which is generally pressurized, to the ionization chamber, various devices capable of controlling the flow, such as pressure limiters, line opening and closing valves, flow controllers, and others, being normally disposed on the said line. The gas is then introduced into the ionization chamber through a suitable distributor whose shape and materials may vary. These distributors may be single nozzles with a single hole, as indicated (Fig. 1) by 1, from which the gas emerges inside the discharge chamber 3, or multiple nozzles 5, with a plurality of outlet holes 5A (Fig. 2) opening into the chamber 7, or of the type indicated in Fig. 3, with a chamber 9 of annular section into which a ring of holes 10 opens. Each ionization chamber comprises means (not illustrated) for generating electrical or magnetic fields for ionization, to split the gas molecules into ions and electrons, and means (not illustrated) for accelerating the ions, for example in a vacuum in the case of electrical thrusters used in the space field.

For high efficiency, it is necessary to create suitable motions of the gas in the chamber in order to ensure the maximum possible ionization. It is also advantageous for good performance to provide a plurality of holes on the same distributor, all of very small section (with a diameter of less than 1 mm, for example), with the risk that a defect at the end of a series of piercings will cause the rejection of the whole piece. Moreover, positioning in different or variable inclinations may be required. These requirements create problems which are conveniently resolved with the invention.

These problems are solved according to the invention by the combination of features of claim 1. Additional advantageous features are set forth in the dependent claims.

Substantially, the present distributor device, comprising at least one nozzle with a calibrated hole for the discharge of the gas into the ionization chamber, is one wherein the calibrated hole is formed in a component made of hard material which is inserted in the wall of the distributor, at the position of a passage formed in the wall.

The said component may be fixed to the wall with an adjustable orientation. In practice, the said component and the wall may have, for mutual contact, complementary surfaces of revolution, which permit variations of orientation of the component; these surfaces may advantageously be portions of spherical surfaces.

The pierced component may be a ruby or other equivalent hard material.

In a device with a plurality of nozzles with calibrated holes, each nozzle may be formed from a pierced component made of hard material.

The said component may be applied to the outside of the wall provided with the passage, or to the inside.

The invention therefore relates to a versatile device which can be used to control the characteristics of the outflow of the gas into the discharge chamber in such a way as to make it, if required, as turbulent as possible, and which may be easily modified so that it can be used in different conditions of gas flow.

Nozzles made of hard material such as ruby are currently used for the production of ultrasonic molecular acceleration devices, as disclosed in A.Danon et al, "Ceramic Nozzle for Molecular Acceleration and its Temperature Measurement", Rev. Sci. Instrum. 58(9), Sept. 1987, pages 1724-1726, and A.Danon et al, "Hyperthermal Surface Ionization: a Novel Ion Source with Analitical Applications", Int. Jour. Mass Spectr. and Jon Proc., 96(1990), pages 139-167. However the purpose for using watch jewels to produce ultrasonic nozzles and the problems solved therewith are different than those which are faced by the present invention and which have been summarized herein before.

The invention will be more clearly understood from the description and the attached drawing which shows a non-restrictive practical example of the invention. In the drawing,
Figs. 1-3 relate to conventional solutions, illustrated schematically and already commented on;
Figs. 4 and 5 show in front view and in the view and partial section along V-V in Fig. 4, a multiple nozzle solution according to the invention;
Figs. 6, 7 and 8 are sections through VI-VIII in variants of a detail of the design; and
Figs. 9 and 10 show another solution, in section and in a view from X-X in Fig. 9.

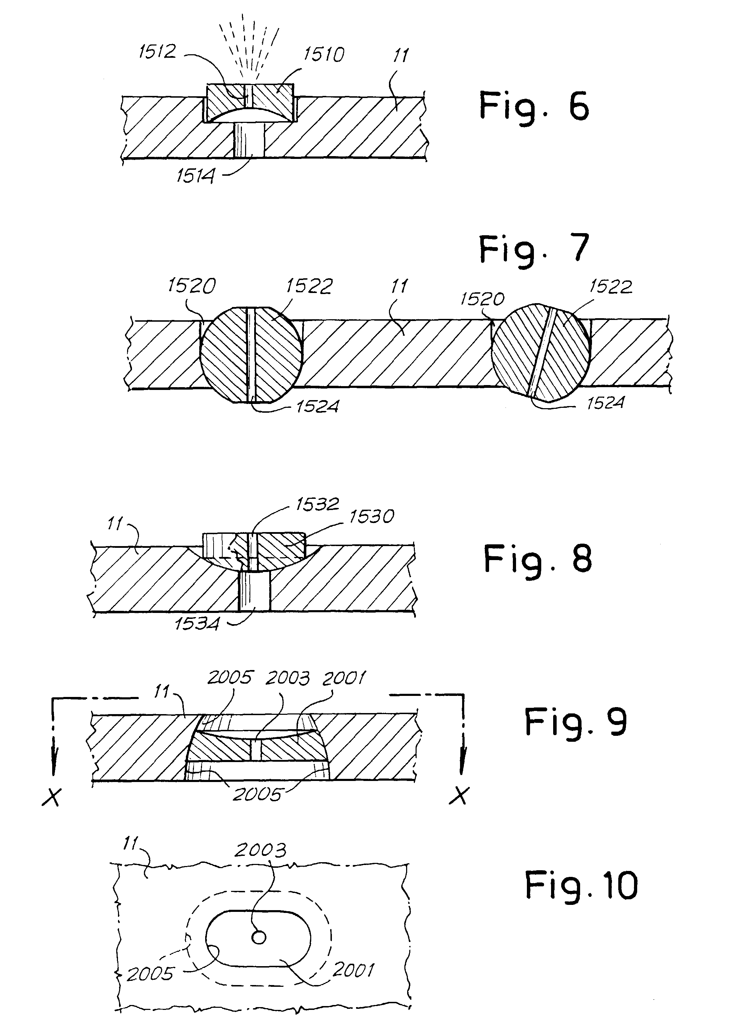

With reference to Figs. 4 and 5, the device comprises a support 11 of suitable shape (in the shape of a ring in the drawing), which has one or more connectors 13 for connection to the gas flow line, which carries the gas from the storage reservoir to the distribution device. The support 11 has a plurality of calibrated holes disposed on one or more faces. These holes - of suitable dimensions - are made in small components 15 made of hard material, for example rubies such as those used in watchmaking; these components 15 are of variable shape and are set with a seal on the principal support 11. Figs. 6-8 show possible but not restrictive examples of pierced components 15.

According to Fig. 6, components 1510 in tablet form are provided, with concavities if required to decrease their thickness, and have calibrated holes 1512 and are partially set in the wall of the distributor 11 at the position of a passage 1514; the tablet 1510 is fixed in the wall with an inclination if necessary, stabilized by the adhesive used for fixing. The fixing may also be achieved by force fitting.

According to Fig. 7, a socket 1520 passing through the wall is provided, with a portion of spherical surface for contact with a component 1522 with a spherical surface pierced by a calibrated through hole 1524; the component 1522 may be fixed in the socket 1520 with a desired inclination within a limiting cone.

Fig. 8 shows a tablet component 1530 with a through hole 1532; complementary surfaces in the form of segments of a sphere are formed by the wall 11, around a passage 1534, and by the tablet component, to permit fixing with a desired angular orientation of the hole 1532.

The components 1510, 1522, 1530 or equivalent may consist of small rubies, with the thin holes for the passage of the gas.

The embodiments described above require the application of the pierced components 1510, 1522, 1530 or other on the outside of the wall 11 of the support forming the main duct for the supply of the nozzle or nozzles. According to a variant, if removable walls are envisaged, the application may be on the inside, with greater protection (by the effect of locking by shape) from the stress of differential pressure between the inside and the outside, in other words the chamber 3.

According to a further variant embodiment, fitting can be from the outside but still with locking by shape. As seen in Figs. 9 and 10, a component 2001 with the calibrated hole 2003 has an oval shape or in any case one of its dimensions is smaller than the dimension perpendicular to it, and the socket 2005 passing through the wall 11 also has corresponding dimensions; the joining surfaces are tapered towards the outside, and may also have suitable curved profiles, to permit the inclined orientation of the component 2001 and the hole 2003. The component 2003, suitably supported, may be introduced lengthways into the passage 2005 and then orientated to be positioned and if necessary glued in the socket formed by the passage 2005, by manipulation from the outside.

According to the invention, the said small components are disposed, during setting, in such a way that the calibrated holes are disposed with the desired inclinations which may be different from each other, to increase the efficiency of the device for the purposes of obtaining turbulence in the discharge within the ionization chamber. The calibrated holes may be different if required.

The use of "hard" components, such as rubies, with previously formed calibrated holes, is advantageous because it enables holes of various dimensions, even extremely small ones, to be used; in commercial rubies, it is possible to have diameters of 0.05 mm with high precision. It is possible to produce calibrated holes by using a well-developed inexpensive technology, thus avoiding the technical difficulties encountered in producing holes with dimensions of 0.05 to 0.25mm in metal. The method is that already in use in mechanical watchmaking.

The use of inserted components such as 15, 1510, 1522, and 1530 is advantageous when it is necessary to create devices with a plurality of outlet holes which may sometimes number up to 90 or 100. The difficulty in making these holes is due to the fact that, during piercing, if even a single hole is faulty the piece has to be completely remade. This risk can be avoided by using calibrated holes already made in hard materials which are subsequently set in the support.

With the described system, it is easy to control precisely, through the number, diameter and direction of the holes in the rubies or other elements made of hard material, the gas outflow parameters (such as the velocity and density of the neutral particles) in proximity to the gas distributor, and in some cases throughout the whole ionization chamber, these parameters being theoretically dependent not only on the shape and disposition of the support in the chamber as a whole and the geometry of the chamber, but also on the type and number of holes present in the gas dispenser element, as is familiar to those skilled in the art and as is well known from the application of the laws of gas dynamics.

The number, diameter and inclination with respect to each other of the calibrated holes from which the gas flows out is of fundamental importance for the determination of the parameters of the gas jet in the discharge chamber.

The distribution of the neutral particles and their velocity in the ionization chamber is important for the performance of the device of which the chamber forms part.

In the case of electric thrusters, the saving of gas is one of the parameters which determines the quality of the thruster; and this saving - for a fixed obtainable thrust and electrical power consumption - may be obtained if there is a high gas ionization efficiency in the discharge chamber. One possible way of obtaining an increase in this efficiency is to attempt to maintain the neutral particles for the longest possible time in the discharge chamber in order to increase the probability of their being ionized and in order to extract only ions responsible for the thrust as a result of the acceleration acquired from the applied electrical fields. The possibility of being able to control - by means of a suitable disposition of the gas distributor (number of holes, their diameter and positioning and orientation of the holes on the support) - the outflow parameters of the gas therefore has advantageous effects in certain applications such as electrical propulsion.

With the system according to the invention it is possible to make the holes interchangeable simply by exchanging the components made of hard material (for example rubies), which are simply set in the principal element, for others with holes of different diameters. The interchangeability of the holes also enables the device to be used in different flow conditions or enables the same device to be used in ionization chambers which are made to operate in completely different gas flow conditions.

Finally, because it is possible to use precisely calibrated holes of various dimensions and of various orientations, the use of a gas distributor in an ionization chamber according to the invention may have positive effects both in terms of the performance of the device and in terms of the cost of the device.

The application of the device according to the invention to plasma motors of the SPT (Stationary Plasma Thruster) type is particularly advantageous.

It is to be understood that the drawing shows only an example provided solely as a practical demonstration of the invention, and that this invention may be varied in its forms and dispositions without departure from the scope of the guiding concept of the invention. The presence of any reference numbers in the enclosed claims has the purpose of facilitating the reading of the claims with reference to the description and to the drawing, and does not limit the scope of protection represented by the claims.

## Claims

1. A ionisation chamber including means for generating electrical or magnetic fields for ionization and a gas distribution device (11) including at least one nozzle (15) with a calibrated hole for the discharge of said gas into said ionisation chamber, characterised in that the calibrated hole (1512; 1524; 1532; 2003) is formed in a component made of hard material (1510; 1522; 1530; 2001), which is inserted in the wall (11) of the distributor at the position of a passage (1514; 1534) formed in the wall.

2. The ionization chamber as claimed in claim 1, wherein the said component (1510; 1522, 1530) is fixed to the wall (11) with an adjustable orientation.

3. The ionization chamber as claimed in claim 2, wherein the said component (1522; 1530) and the wall have, for mutual contact, complementary surfaces of revolution, which permit variations of orientation of the component.

4. The ionization chamber as claimed in claim 3, wherein the said component and the wall have, for mutual contact, portions of spherical surfaces.

5. The ionization chamber as claimed in at least one of claims 1-4, wherein the said component is made of ruby or other equivalent hard material.

6. The ionization chamber as claimed in at least claim 1, with a plurality of nozzles with calibrated holes, wherein each nozzle has a pierced component made of hard material to provide calibrated holes of different sections and/or different orientations.

7. The ionization chamber as claimed in at least one of claims 1-6, wherein a pierced component (1510, 1522, 1530) is applied by puttying and/or by mechanical forcing on the outside of the wall forming the support and main duct.

8. The ionization chamber as claimed in at least one of claims 1-6, wherein a pierced component (2003) may be inserted through a passage (2005) and is positioned in the said passage from the inside.

## Patentansprüche

1. Ionisationskammer mit Mitteln zum Erzeugen von elektrischen oder magnetischen Feldern für die Ionisation und einer Gasverteilvorrichtung (11) mit mindestens einer Düse (15) mit einem kalibrierten Loch für den Austritt des Gases in die Ionisationskammer,
dadurch **gekennzeichnet**, daß das kalibrierte Loch (1512; 1524; 1532; 2003) in einer Komponente aus hartem Material (1510; 1522; 1530; 2001) ausgebildet ist, welche in die Wand (11) des Verteilers am Ort eines in der Wand ausgebildeten Durchlasses (1514; 1534) eingesetzt ist.

2. Ionisationskammer nach Anspruch 1, bei der die Komponente (1510; 1522; 1530) in der Wand (11) mit einstellbarer Orientierung befestigt ist.

3. Ionisationskammer nach Anspruch 2, bei der die Komponente (1522; 1530) und die Wand komplementäre Rotationsflächen für die gegenseitige Anlage aufweisen, die Veränderungen der Orientierung der Komponente ermöglichen.

4. Ionisationskammer nach Anspruch 3, bei der die Komponente und die Wand Teile von sphärischen Flächen für die gegenseitige Anlage haben.

5. Ionisationskammer nach mindestens einem der Ansprüche 1 bis 4, bei der die Komponente aus Rubin oder aus einem anderen äquivalenten harten Material besteht.

6. Ionisationskammer mindestens nach Anspruch 1, mit einer Anzahl von Düsen mit kalibrierten Löchern, bei der jede Düse eine durchlöcherte Komponente aus hartem Material aufweist zur Bereitstellung von kalibrierten Löchern mit unterschiedlichen Querschnitten und/oder unterschiedlichen Orientierungen.

7. Ionisationskammer nach mindestens einem der Ansprüche 1 bis 6, bei der eine durchlöcherte Komponente (1510; 1522; 1530) angebracht wird durch Kitten und/oder durch mechanisches Einpressen an der Außenseite der die Halterung und den Hauptströmungskanal bildenden Wand.

8. Ionisationskammer nach mindestens einem der Ansprüche 1 bis 6, bei der eine durchlöcherte Komponente (2003) durch einen Durchlaß (2005) einführbar ist und in dem Durchlaß von der Innenseite her positioniert ist.

## Revendications

1. Chambre d'ionisation comprenant des moyens pour produire des champs électriques ou magnétiques pour l'ionisation et un dispositif de distribution de gaz (11) comprenant au moins une buse (15) pourvue d'un trou calibré pour la décharge dudit gaz dans la chambre d'ionisation, caractérisé en ce que le trou calibré (1512 ; 1524 ; 1523 2003) est formé dans un composant réalisé en un matériau dur (1510; 1522 ; 1530 ;2001), qui est inséré dans la paroi (11) du distributeur dans la position d'un passage (1514 ; 1534) formé dans la paroi.

2. Chambre d'ionisation selon la revendication 1, dans laquelle ledit composant (1510 ; 1522; 1530) est fixé à la paroi (11) avec une orientation réglable.

3. Chambre d'ionisation selon la revendication 2, dans laquelle ledit composant (1522 ; 1530) et la paroi possèdent, pour un contact mutuel, des surfaces complémentaires de révolution, qui permettent des modifications de l'orientation du composant.

4. Chambre d'ionisation selon la revendication 3, dans laquelle le composant et la paroi possèdent, pour un contact mutuel, des parties de surfaces sphériques.

5. Chambre d'ionisation selon au moins l'une des revendications 1-4, dans laquelle ledit composant est constitué d'un rubis ou d'un autre matériau dur équivalent.

6. Chambre d'ionisation selon au moins la revendication 1, comportant une pluralité de buses pourvues de trous calibrés, chaque buse possédant un composant perforé formé d'un matériau dur de manière à réaliser des trous calibrés de différentes sections et/ou ayant différentes orientations.

7. Chambre d'ionisation selon au moins l'une des revendications 1-6, dans laquelle un composant perforé (1510, 1522, 1530) est appliqué par masticage et/ou par montage mécanique à force sur l'extérieur de la paroi formant le support et le conduit principal.

8. Chambre d'ionisation selon l'une des revendications 1-6, dans laquelle un composant perforé (2003) peut être inséré dans un passage (2005) et positionné à partir de l'intérieur dans le passage.
